# EUROPEAN PATENT SPECIFICATION

(11) **EP 4 204 505 B1**
(45) Date of publication and mention of the grant of the patent: **05.11.2025**
(21) Application number: 21862647.1
(22) Date of filing: 25.08.2021
(51) Int. Cl.: C09G 1/02, H01L 21/304

(54) **POLISHING COMPOSITIONS AND METHODS OF USING THE SAME**
POLIERZUSAMMENSETZUNGEN UND VERFAHREN ZUR VERWENDUNG DAVON
COMPOSITIONS DE POLISSAGE ET LEURS PROCÉDÉS D'UTILISATION

(30) Priority: 28.08.2020 US 202063071711 P
(43) Date of publication of application: 05.07.2023
(73) Proprietor: FUJIFILM Electronic Materials U.S.A, Inc., North Kingstown, Rhode Island 02852 (US)
(72) Inventor: SCHAEFER, Zachary L., Mesa, Arizona 85208 (US); TURNER, Eric, Phoenix, Arizona 85009 (US); BALLESTEROS, Carl, San Tan Valley, Arizona 85143 (US)
(74) Representative: Fish & Richardson P.C.
(86) International application number: PCT/US2021/047534
(87) International publication number: WO 2022/046893

(56) References cited:
- EP-A1- 1 953 237
- EP-A1- 3 101 076
- CN-A- 103 820 079
- DK-T3- 3 290 500
- US-A1- 2018 244 532
- US-A1- 2019 060 461

## Description

### CROSS-REFERENCE TO RELATED APPLICATION

The present application claims priority to U.S. Provisional Application Serial No. 63/071,711, filed on August 28, 2020.

### BACKGROUND

The semiconductor industry is continually driven to improve chip performance by further miniaturization of devices through process and integration innovations. Chemical Mechanical Polishing/Planarization (CMP) is a powerful technology as it makes many complex integration schemes at the transistor level possible, thereby facilitating increased chip density.

CMP is a process used to planarize/flatten a wafer surface by removing material using abrasion-based physical processes concurrently with surface-based chemical reactions. In general, a CMP process involves applying a CMP slurry (aqueous chemical formulation) to a wafer surface while contacting the wafer surface with a polishing pad and moving the polishing pad in relation to the wafer. Slurries typically include an abrasive component and dissolved chemical components, which can vary significantly depending upon the materials (e.g., metals, metal oxides, metal nitrides, dielectric materials such as silicon oxide, silicon nitride, etc.) present on the wafer that will be interacting with the slurry and the polishing pad during the CMP process. CN103820079A describes an abrasive composition for gallium nitride material. EP3101076A1 describes CMP slurries using ceria-coated silica abrasives.

### SUMMARY

The present invention is defined by independent claim 1. The dependent claims depict additional embodiments of the invention.

This summary is provided to introduce a selection of concepts that are further described below in the detailed description. This summary is not intended to identify key or essential features of the claimed subject matter, nor is it intended to be used as an aid in limiting the scope of the claimed subject matter.

In one aspect, this disclosure features a polishing composition that includes at least one abrasive; at least one pH adjuster; and at least one biosurfactant selected from the group consisting of glycolipids, lipopeptides, and mixtures thereof, wherein the polishing composition is free of non-ionic polymers.

In another aspect, this disclosure features a method of polishing a substrate that includes the steps of applying a polishing composition described herein to a surface of the substrate; and bringing a pad into contact with the surface of the substrate and moving the pad in relation to the substrate.

### DETAILED DESCRIPTION

The present disclosure relates to polishing compositions and methods for polishing semiconductor substrates using the same.

In some embodiments, this disclosure relates to polishing compositions that include at least one biosurfactant. As used herein, the term "biosurfactant" is intended to denote amphiphilic organic molecules, such as organic molecules that include both hydrophobic groups (e.g., an alkyl chain) and hydrophilic groups (e.g., a carboxylic acid group), which are produced by a biological organism (e.g., a microorganism). Commonly used surfactants in the CMP industry are produced using petroleum based precursors and/or energy intensive chemical reactions. In contrast, a biosurfactant can have a favorable environmental and energy profile (e.g., biodegradability and/or production by less energy intensive processes), while still being capable of providing the performance characteristics necessary to execute advanced CMP operations. Additionally, due to their unique chemical structures, biosurfactants can also impart enhanced performance (e.g., improved polishing selectivity between substrate constituents by reducing removing rates of certain dielectric and/or metal films) during CMP operations when used alone or in combination with surfactants that are not biosurfactants. Thus, the use of biosurfactants within the CMP industry presents an opportunity for improved or sustained performance combined with a significantly reduced environmental footprint.

In one or more embodiments, a polishing composition described herein can include at least one abrasive, at least on pH adjuster, and at least one biosurfactant, wherein the polishing composition is free of non-ionic polymers. In one or more embodiments, a polishing composition according to the present disclosure can include from about 0.01% to about 50% by weight of at least one abrasive, from about 0.0001% to about 30% by weight of at least one pH adjuster, from about 0.0001% to about 10% by weight of at least one biosurfactant, and the remaining percent by weight (e.g., from about 30% to about 99.99% by weight) of a solvent (e.g., deionized water).

In one or more embodiments, the present disclosure provides a concentrated polishing composition that can be diluted with water prior to use by up to a factor of two, or up to a factor of four, or up to a factor of six, or up to a factor of eight, or up to a factor of ten, or up to a factor of fifteen, or up to a factor of twenty. In other embodiments, the present disclosure provides a point-of-use (POU) polishing composition, comprising the above-described polishing composition, water, and optionally an oxidizer.

In one or more embodiments, a POU polishing composition can include from about 0.01% to about 25% by weight of at least one abrasive, from about 0.0001% to about 10% by weight of at least one pH adjuster, from about 0.0001% to about 5% by weight of at least one biosurfactant, and the remaining percent by weight (e.g., from about 65% to about 99.99% by weight) of a solvent (e.g., deionized water).

In one or more embodiments, a concentrated polishing composition can include from about 0.02% to about 50% by weight of at least one abrasive, from about 0.0002% to about 30% by weight of at least one pH adjuster, from about 0.0002% to about 10% by weight of at least one biosurfactant, and the remaining percent by weight (e.g., from about 35% to about 99.98% by weight) of a solvent (e.g., deionized water).

In one or more embodiments, the at least one (e.g., two or three) abrasive is selected from the group consisting of cationic abrasives, substantially neutral abrasives, and anionic abrasives. In one or more embodiments, the at least one abrasive is selected from the group consisting of alumina, silica, titania, ceria, zirconia, co-formed products thereof (i.e., co-formed products of alumina, silica, titania, ceria, or zirconia), coated abrasives, surface modified abrasives, and mixtures thereof. In some embodiments, the at least one abrasive does not include ceria. In some embodiments, the at least one abrasive has a high purity, and can have less than about 100 ppm of alcohol, less than about 100 ppm of ammonia, and less than about 100 ppb of an alkali cation such as sodium cation. The abrasive can be present in an amount of from about 0.01% to about 12% (e.g., from about 0.5% to about 10%), based on the total weight of a POU polishing composition, or any subranges thereof.

In one or more embodiments, the abrasive is a silica-based abrasive, such as one selected from the group consisting of colloidal silica, fumed silica, and mixtures thereof. In one or more embodiments, the abrasive can be surface modified with organic groups and/or non-siliceous inorganic groups. For example, the cationic abrasive can include terminal groups of formula (I):

-Oₘ-X-(CH₂)ₙ-Y (I),

in which m is an integer from 1 to 3; n is an integer from 1 to 10; X is Al, Si, Ti, Ce, or Zr; and Y is a cationic amino or thiol group. As another example, the anionic abrasive can include terminal groups of formula (I):

-Oₘ-X-(CH₂)ₙ-Y (I),

in which m is an integer from 1 to 3; n is an integer from 1 to 10; X is Al, Si, Ti, Ce, or Zr; and Y is an acid group.

In one or more embodiments, the abrasive described herein can have a mean particle size of at least about 1 nm (e.g., at least about 5 nm, at least about 10 nm, at least about 20 nm, at least about 40 nm, at least about 50 nm, at least about 60 nm, at least about 80 nm, or at least about 100 nm) to at most about 1000 nm (e.g., at most about 800 nm, at most about 600 nm, at most about 500 nm, at most about 400 nm, or at most about 200 nm). As used herein, the mean particle size (MPS) is determined by dynamic light scattering techniques.

In one or more embodiments, the at least one abrasive is in an amount of from at least about 0.01% (e.g., at least about 0.05%, at least about 0.06%, at least about 0.08%, at least about 0.1%, at least about 0.2%, at least about 0.4%, at least about 0.5%, at least about 0.6%, at least about 0.8%, at least about 1%, at least about 1.2%, at least about 1.5%, or at least about 2%) by weight to at most about 50% (e.g., at most about 45%, at most about 40%, at most about 35%, at most about 30%, at most about 25%, at most about 20%, at most about 15%, at most about 12%, at most about 10%, %, at most about 8%, %, at most about 6%, at most about 5%, %, at most about 4%, %, at most about 2%, or %, at most about 1%,) by weight of the polishing compositions described herein.

In one or more embodiments, the polishing compositions described herein can include at least one (e.g., two or three) pH adjustor, if necessary, to adjust the pH to a desired value. In some embodiments, the at least one pH adjustor can be an acid (e.g., an organic or inorganic acid) or a base (e.g., an organic or inorganic base). For example, the pH adjustor can be selected from the group consisting of nitric acid, hydrochloric acid, sulfuric acid, propionic acid, citric acid, malonic acid, hydrobromic acid, hydroiodic acid, perchloric acid, ammonia, ammonium hydroxide, sodium hydroxide, potassium hydroxide, cesium hydroxide, monoethanolamine, diethanolamine, triethanolamine, methylethanolamine, methyldiethanolamine tetrabutylammonium hydroxide, tetrapropylammonium hydroxide, tetraethylammonium hydroxide, tetramethylammonium hydroxide, ethyltrimethylammonium hydroxide, diethyldimethylammonium hydroxide, dimethyldipropylammonium hydroxide, benzyltrimethylammonium hydroxide, tris(2-hydroxyethyl)methylammonium hydroxide, choline hydroxide, and any combinations thereof.

In one or more embodiments, the at least one pH adjuster is in an amount of from at least about 0.0001% (e.g., at least about 0.0005%, at least about 0.001%, at least about 0.002%, at least about 0.004%, at least about 0.005%, at least about 0.006%, at least about 0.008%, at least about 0.01%, at least about 0.02%, at least about 0.04%, at least about 0.05%, at least about 0.06%, at least about 0.08%, at least about 0.1%, at least about 0.2%, at least about 0.4%, at least about 0.5%, at least about 0.6%, at least about 0.8%, at least about 1%, at least about 1.5%, at least about 2%, at least about 2.5%, at least about 3%, at least about 4%, or at least about 5%) by weight to at most about 30% (e.g., at most about 25%, at most about 20%, at most about 15%, at most about 12%, at most about 10%, at most about 9%, at most about 8%, at most about 7%, at most about 6%, at most about 5%, at most about 4%, at most about 3%, at most about 2.5%, at most about 2%, at most about 1.5%, at most about 1%, at most about 0.5%, at most about 0.2%, or at most about 0.1%) by weight of the polishing compositions described herein.

In one or more embodiments, the polishing compositions described herein can be either acidic or basic. In some embodiments, the polishing compositions can have a pH ranging from at least about 1 to at most about 14. When the polish compositions are acidic, the pH can range from at least about 1 (e.g., at least about 1.5, at least about 2, at least about 2.5, at least about 3, at least about 3.5, at least about 4, at least about 4.5, or at least about 5) to at most about 7 (e.g., at most about 6.5, at most about 6, at most about 5.5, at most about 5, at most about 4.5, or at most about 4). When the polishing compositions are basic, the pH can range from at least about 7 (e.g., at least about 7.5, at least about 8, at least about 8.5, at least about 9, at least about 9.5, at least about 10, at least about 10.5, at least about 11, at least about 11.5, or at least about 12) to at most about 14 (e.g., at most about 13.5, at most about 13, at most about 12.5, at most about 12, at most about 11.5, at most about 11, at least about 10.5, or at most about 10).

In one or more embodiments, the polishing compositions can include at least one (e.g., two or three) biosurfactant. In one or more embodiments, the at least one biosurfactant can be a microbial growth by-product (i.e., the biosurfactant can be produced by microorganisms), such as a microbial metabolite. The microbial growth by-product (i.e., the biosurfactant) can be collected from a cultivated yeast or fungus strain (i.e., the microorganisms) through a purification process that removes the microorganisms involved in producing the microbial growth by-product.

In one or more embodiments, the biosurfactant can be selected from the group consisting of glycolipids, lipopeptides, and mixtures thereof. In one or more embodiments, the biosurfactant includes a glycolipid selected from the group consisting of a rhamnolipid, a sophorolipid, a trehalose lipid, a mannosylerythritol lipid, and mixtures thereof. In one or more embodiments, the biosurfactant includes a lipopeptide selected from the group consisting of surfactin, iturin, fengycin, lichenysin, and mixtures thereof.

In one or more embodiments, the glycolipid is a rhamnolipid biosurfactant selected from a mono-rhamnolipid, a di-rhamnolipid, and mixtures thereof. Rhamnolipid biosurfactants are surface active compounds released by microorganisms. They are biodegradable, non-toxic, and eco-friendly materials. Their production depends on the fermentation conditions, environmental factors and nutrient availability. In some embodiments, rhamnolipids have a glycosyl head group (i.e., a rhamnose moiety), and a fatty acid tail (e.g., containing one or more (e.g., two or three) C₁₀-C₁₄ 3-hydroxyalkanoic acid or ester group). In some embodiments, depending on the fermentation details, a rhamnolipid's fatty acid tail can be 10-28 (e.g., 20-28 or 24-28) carbons long. In some embodiments, the fatty acid tail can include a 3-(hydroxyalkanoyloxy)alkanoic acid (HAA) group. For example, the fatty acid tail can include a group of formula (II): -R₁-C(O)O-R₂-COOH, in which each of R₁ and R₂, independently, is a C₁₀-C₁₄ straight chained or branched alkylene group.

Structure I shows the structure of a typical mono-rhamnolipid, RLL or R1 (alpha-L-Rhamnopyranosyl-beta-hydroxydecanoyl-beta-hydrooxydecanoate, C₂₆H₄₈O₉ (504 g/mol):

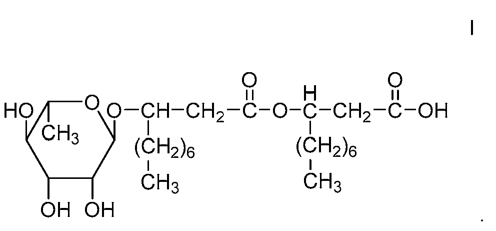

Structure II shows a structure of a typical di-rhamnolipid, RRLL or R2 (2-O-alpha-L-rhamnopyranosyl-alpha-L-rhamnopyranosyl-beta-hydroxydecanoyl-beta-hydrooxydecanoate, C₃₂H₅₈O₁₃ (650 g/mol):

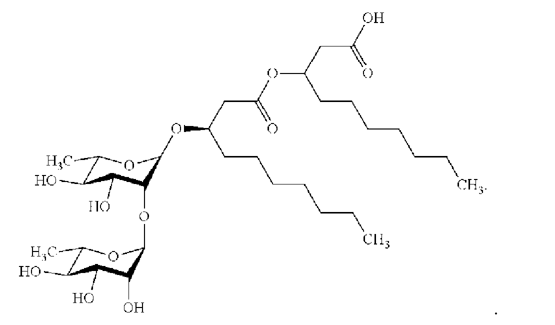

As mentioned above, there are two major groups of rhamnolipids; mono-rhamnolipids and di-rhamnolipids. Mono-rhamnolipids have a single rhamnose sugar ring. A common name for mono-rhamnolipid RLL (which is most often produced by P. aeruginosa) is: L-rhamnosyl-beta-hydroxydecanoyl-beta-hydroxydecanoate (often referred to as Rha-C10-C10) with a formula of C₂₆H₄₈O₉. The IUPAC Name is 3-[3-[(2R,3R,4R,5R,6S)-3,4,5-trihydroxy-6-methyloxan-2-yl]oxydecanoyloxy]decanoic acid.

Di-rhamnolipids have two rhamnose sugar rings. A common name for di-rhamnolipid RRLL is: L-rhamnosyl-L-rhamnosyl-beta-hydroxydecanoyl-beta-hydroxydecanoate (often referred to as Rha-Rha-C10-C10) with a formula of C₃₂H₅₈O₁₃. The IUPAC Name is: 3-[3-[4,5-dihydroxy-6-methyl-3-(3,4,5-trihydroxy-6-methyloxan-2-yl)oxyoxan-2-yl]oxydecanoyloxy]decanoic acid. Some other forms or names for the more common di-rhamnolipids include: L-rhamnopyranosyl-L-rhamnopyranosyl-beta-hydroxydecanoyl-beta-hydroxydecanoate (often referred to as Rha-Rha-C 10-C 10), L-rhamnopyranosyl-L-rhamnopyranosyl-beta-hydroxydecanoyl-beta-hydroxydodecanoate (often referred to as Rha-Rha-C10-C12), and L-rhamnopyranosyl-L-rhamnopyranosyl-beta-hydroxytetradecanoyl-beta-hydroxytetradecanoate (often referred to as Rha-Rha-C14-C14).

Rhamnolipid formulations for use as biosurfactants in the polishing compositions of the present disclosure can be crude or highly purified rhamnolipids. A crude rhamnolipid formulation contains a rhamnolipid, having many impurities which can include both external impurities (e.g., those arising from the biological production method), and/or a variety of various rhamnolipid mixtures, which can cause a reduced effect on the formulation. A highly purified rhamnolipid formulation contains rhamnolipids whose external impurities have been removed, and/or rhamnolipids (e.g., di-rhamnolipids, mono-rhamnolipids, or a mixture thereof) that have been purified to meet certain parameters (e.g., weight ratio of mono- to di-rhamnolipids) to cause an increased effect on the formulation. In one or more embodiments, the weight % ratio of mono-rhamnolipid to di-rhamnolipid in the polishing compositions is in the range of between about 0.1:99.9 and 99.9:0.1, respectively. For example, the weight % ratio of mono-rhamnolipid to di-rhamnolipid in the polishing compositions can be from at least about 0.1:99.9 (e.g., at least about 0.5:99.5, at least about 1:99, at least about 5:95, at least about 10:90, at least about 15:85, at least about 20:80, at least about 25:75, at least about 30:70, at least about 35:65, at least about 40:60, at least about 45:55, or at least about 50:50) to at most about 99.9:0.1 (e.g., at most about 99.5:0.5, at most about 99:1, at most about 95:5, at most about 90:10, at most about 85:15, at most about 80:20, at most about 75:25, at most about 70:30, at most about 65:35, at most about 60:40, at most about 55:45, or at most about 50:50).

In one or more embodiments, the rhamnolipid formulations are made by eliminating unwanted impurities from the initial mixture obtained from a microorganism and then establishing the percentage and type of rhamnolipid to be present in the final polishing composition, and simply diluting the rhamnolipid formulations by addition into/with the solvent used for the polishing composition. Crude rhamnolipid formulations and highly purified rhamnolipid formulations can be prepared by methods well-known to those of skill in the art. In some embodiments, rhamnolipid formulations for use as biosurfactants in the polishing compositions described herein can include at least about 50% (e.g., at least about 55%, at least about 65%, at least about 70%, at least about 75%, at least about 80%, at least about 85%, at least about 90%, at least about 95%, at least about 98%, at least about 99%, at least about 99.5%, or at least about 99.9%) by weight rhamnolipid.

In one or more embodiments, the glycolipid is a sophorolipid biosurfactant. Sophorolipids (also known as sophorose lipids or SLs) are a group of biosurfactants consisting of a dimeric sugar (sophorose) and a hydroxyl fatty acid, linked by a beta-glycosidic bond. There are two types of SLs, namely, the acidic (non-lactonic) SLs and the lactonic SLs. The hydroxyl fatty acid moiety of the acidic SLs has a free carboxylic acid functional group, while that of the lactonic SLs forms a macrocyclic lactone ring with the 4"-hydroxyl group of the sophorose by intramolecular esterification. Sophorose lipids are generally categorized into two forms: (1) the lactone form represented by the following structural formula (III): 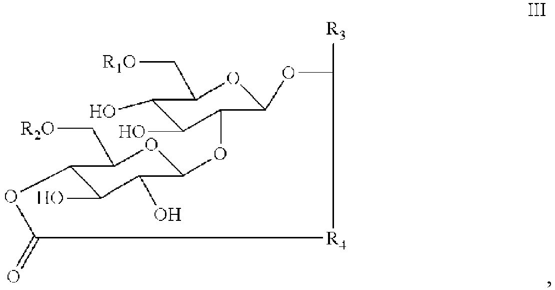 wherein R₁ and R₂ each represent H or COCH₃; R₃ represents H or CH₃; and R₄ represents a saturated or unsaturated C₁₂-₁₆ hydrocarbon group (e.g., a C₁₂-₁₆ alkylene group optionally containing one or more (e.g., 2, 3, 4, or 5) double bonds) when R₃ is H, and R₄ represents a saturated or unsaturated C₁₁-₁₅ hydrocarbon group (e.g., a C₁₁-₁₅ alkylene group optionally containing one or more (e.g., 2, 3, 4, or 5) double bonds) when R₃ is CH₃, and (2) the acid form represented by the following formula (IV): 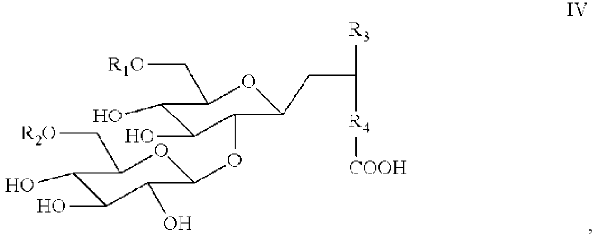 wherein R₁ to R₄ are as defined above. A commercial example of a sophorolipid biosurfactant is REWOFERM SL ONE available from Evonik (Essen, Germany), which includes a mixture of sophorolipids (i.e., lactone and acid forms) produced by fermenting glucose, fatty acids, and C18 unsaturated esters with glycerol in the presence of yeast *Candida Bombicola* and includes about 30-50 wt% sophorolipids.

As is clear from the above, sophorose lipids have a number of derivatives which are characterized by the positions and number of acetyl groups, the presence or absence of double bonds in the fatty acid side chain, the length of the carbon chain of the fatty acid side chain, the position of the glycosidic ether bond in the fatty acid side chain, the positions of hydroxyl groups on the sophorose moiety that is a part of a lactone ring, and other structural parameters. Sophorose lipids generally occur as a mixture of these compounds. In general, sophorose lipids are produced in a highly viscous oil form that is difficult to handle. However, sophorose lipids in the diacetyl lactone form, which are comparatively high in hydrophobicity, can be produced in a solid form. In one or more embodiments, the glycolipid is a sophorolipid that includes at least about 5% (e.g., at least about 10%, at least about 15%, at least about 20%, at least about 25%, at least about 30%, at least about 35%, at least about 40%, at least about 45%, or at least about 50%) by weight to at most about 95% (e.g., at most about 90%, at most about 85%, at most about 80%, at most about 75%, at most about 70%, at most about 65%, at most about 60%, at most about 55%, at most about 50%) by weight acidic-type sophorolipid.

In one or more embodiments, the biosurfactant is in an amount of from at least about 0.0001% (e.g., at least about 0.0005%, at least about 0.001%, at least about 0.002%, at least about 0.004%, at least about 0.005%, at least about 0.006%, at least about 0.008%, at least about 0.01%, at least about 0.02%, at least about 0.03%, at least about 0.04%, at least about 0.05%, at least about 0.1%, at least about 0.5%, at least about 1%, at least about 1.5%, at least about 2%, at least about 2.5%, at least about 3%, at least about 4%, or at least about 5%) by weight to at most about 10% (e.g., at most about 9%, at most about 8%, at most about 7%, at most about 6%, at most about 5%, at most about 4%, at most about 3%, at most about 2%, at most about 1%, at most about 0.5%, at most about 0.2%, at most about 0.1%, or at most about 0.05%) by weight of the polishing compositions described herein.

In one or more embodiments, one or more (e.g., two or three) biosurfactants are the only surfactant(s) in the polishing compositions described herein. However, in some embodiments, the polishing compositions can also include one or more (e.g., two or three) additional surfactants, distinct from the biosurfactant, selected from the group consisting of anionic surfactants, non-ionic surfactants, amphoteric surfactants, cationic surfactants, and mixtures thereof.

The cationic surfactant is not particularly limited, but specific examples thereof include aliphatic amine salts and aliphatic ammonium salts.

The non-ionic surfactant is not particularly limited, but specific examples thereof include an ether-type surfactant, an ether ester-type surfactant, an ester-type surfactant, and an acetylene-based surfactant. The ether-type surfactant is not particularly limited, but specific examples thereof include polyethylene glycol mono-4-nonylphenyl ether, polyethylene glycol monooleyl ether, and triethylene glycol monododecyl ether. The ether ester-type surfactant is not particularly limited, but a specific example thereof is a polyoxyethylene ether of a glycerin ester. The ester-type surfactant is not particularly limited, but specific examples thereof include a polyethylene glycol fatty acid ester, a glycerin ester, and a sorbitan ester. The acetylene-based surfactant is not particularly limited, but specific examples thereof include ethylene oxide adducts of acetylene alcohol, acetylene glycol, and acetylene diol.

The amphoteric surfactant is not particularly limited, but specific examples thereof include betaine-based surfactants.

The anionic surfactant is not particularly limited, but specific examples thereof include carboxylic acid salts, sulfonic acid salts, sulfate salts, and phosphate salts. The carboxylic acid salts are not particularly limited, but specific examples thereof include fatty acid salts (e.g., soaps) and alkyl ether carboxylic acid salts. Examples of the sulfonic acid salts include alkylbenzenesulfonic acid salts, alkylnaphthalenesulfonic acid salts, and α-olefin sulfonic acid salts. The sulfate salts are not particularly limited, but specific examples thereof include higher alcohol sulfate salts and alkyl sulfate salts. The phosphates are not particularly limited, but specific examples thereof include alkyl phosphates and alkyl ester phosphates.

When the polishing compositions described herein include a second surfactant distinct from the biosurfactant described above, the amount of the second surfactant can range from at least about 0.001% (e.g., at least about 0.002%, at least about 0.003%, at least about 0.005%, at least about 0.01%, at least about 0.05%, or at least about 0.1%) by weight to at most about 1% (e.g., at most about 0.8%, at most about 0.6%, at most about 0.5%, at most about 0.4%, at most about 0.2%, or at most about 0.1%) by weight of the total mass of the polishing compositions.

In one or more embodiments, the polishing compositions described herein can further include at least one (e.g., two, three, or four) optional additive selected from the group consisting of an azole compound, a corrosion inhibitor, an oxidizer, a chelating agent, a water-soluble polymer, wherein the water-soluble polymer is selected from the group consisting of polyacrylamide, polyvinylpyrrolidone, polyacrylic acid, and hydroxyethyl cellulose, and a nitride removal rate reducing agent.

The azole compound is not particularly limited, but specific examples thereof include substituted or unsubstituted triazoles (e.g., benzotriazoles), substituted or unsubstituted tetrazoles, substituted or unsubstituted diazoles (e.g., imidazoles, benzimidazoles, thiadiazoles, and pyrazoles), and substituted or unsubstituted benzothiazoles. Herein, a substituted diazole, triazole, or tetrazole refers to a product obtained by substitution of one or two or more hydrogen atoms in the diazole, triazole, or tetrazole with, for example, a carboxyl group, an alkyl group (e.g., a methyl, ethyl, propyl, butyl, pentyl, or hexyl group), a halogen group (e.g., F, Cl, Br, or I), an amino group, or a hydroxyl group. In one or more embodiments, the azole compound can be selected from the group consisting of tetrazole, benzotriazole, tolyltriazole, methyl benzotriazole (e.g., 1-methyl benzotriazole, 4-methyl benzotriazole, and 5-methyl benzotriazole), ethyl benzotriazole (e.g., 1-ethyl benzotriazole), propyl benzotriazole (e.g., 1-propyl benzotriazole), butyl benzotriazole (e.g., 1-butyl benzotriazole and 5-butyl benzotriazole), pentyl benzotriazole (e.g., 1-pentyl benzotriazole), hexyl benzotriazole (e.g., 1-hexyl benzotriazole and 5-hexyl benzotriazole), dimethyl benzotriazole (e.g., 5,6-dimethyl benzotriazole), chloro benzotriazole (e.g., 5-chloro benzotriazole), dichloro benzotriazole (e.g., 5,6-dichloro benzotriazole), chloromethyl benzotriazole (e.g., 1-(chloromethyl)-1-H-benzotriazole), chloroethyl benzotriazole, phenyl benzotriazole, benzyl benzotriazole, aminotriazole, aminobenzimidazole, pyrazole, imidazole, aminotetrazole, adenine, benzimidazole, thiabendazole, 1,2,3-triazole, 1,2,4-triazole, 1-hydroxybenzotriazole, 2-methylbenzothiazole, 2-aminobenzimidazole, 2-amino-5-ethyl-1,3,4-thiadiazole, 3,5-diamino-1,2,4-triazole, 3-amino-5-methylpyrazole, 4-amino-4H-1,2,4-triazole, and combinations thereof. Without wishing to be bound by theory, it is believed that the azole compounds can be used as a corrosion inhibitor in the polishing compositions described herein to reduce the removal of certain materials (e.g., metals or dielectric materials) during the polishing process.

**In** some embodiments, the azole compound can be from at least about 0.001% (e.g., at least about 0.002%, at least about 0.004%, at least about 0.005%, at least about 0.006%, at least about 0.008%, at least about 0.01%, at least about 0.02%, at least about 0.04%, at least about 0.05%, at least about 0.06%, at least about 0.08%, or at least about 0.1%) by weight to at most about 0.2% (e.g., at most about 0.18%, at most about 0.16%, at most about 0.15%, at most about 0.14%, at most about 0.12%, at most about 0.1%, at most about 0.08%, at most about 0.06%, at most about 0.05%, at most about 0.04%, at most about 0.03%, at most about 0.02%, or at most about 0.01%) by weight of the polishing compositions.

**In** some embodiments, the polishing compositions described herein can optionally include a non-azole corrosion inhibitor. Examples of non-azole corrosion inhibitors include alkylamines (e.g., ethylamine, propylamine, or butylamine) and organic phosphonic acids (e.g., ethylphosphonic acid).

**In** some embodiments, the non-azole corrosion inhibitor can be from at least about 0.001% (e.g., at least about 0.002%, at least about 0.004%, at least about 0.005%, at least about 0.006%, at least about 0.008%, at least about 0.01%, at least about 0.02%, at least about 0.04%, at least about 0.05%, at least about 0.06%, at least about 0.08%, or at least about 0.1%) by weight to at most about 0.2% (e.g., at most about 0.18%, at most about 0.16%, at most about 0.15%, at most about 0.14%, at most about 0.12%, at most about 0.1%, at most about 0.08%, at most about 0.06%, at most about 0.05%, at most about 0.04%, at most about 0.03%, at most about 0.02%, or at most about 0.01%) by weight of the polishing compositions described herein.

The oxidizing agent is not particularly limited, but specific examples thereof include ammonium persulfate, potassium persulfate, hydrogen peroxide, ferric nitrate, diammonium cerium nitrate, iron sulfate, hypochlorous acid, ozone, potassium periodate, and peracetic acid. Without wishing to be bound by theory, it is believed that the oxidizing agent can facilitate the removal of materials during the polishing process.

In some embodiments, the oxidizing agent can be from at least about 0.1% (e.g., at least about 0.2%, at least about 0.3%, at least about 0.4%, at least about 0.5%, at least about 0.6%, at least about 0.7%, at least about 0.8%, at least about 0.9%, at least about 1%, at least about 1.5%, or at least about 2%) by weight to at most about 10% (e.g., at most about 9%, at most about 8%, at most about 7%, at most about 6%, at most about 5%, at most about 4%, at most about 3%, at most about 2%, or at most about 1%) by weight of the polishing compositions described herein.

In one or more embodiments, the chelating agent can be selected from the group consisting of gluconic acid, lactic acid, citric acid, tartaric acid, malic acid, glycolic acid, malonic acid, formic acid, oxalic acid, acetic acid, propionic acid, peracetic acid, succinic acid, lactic acid, amino acetic acid, phenoxyacetic acid, bicine, diglycolic acid, glyceric acid, tricine, alanine, histidine, valine, phenylalanine, proline, glutamine, aspartic acid, glutamic acid, arginine, lysine, tyrosine, benzoic acid, ammonia, 1,2-ethanedisulfonic acid, 4-amino-3-hydroxy-1-naphthalenesulfonic acid, 8-hydroxyquinoline-5-sulfonic acid, aminomethanesulfonic acid, benzenesulfonic acid, hydroxylamine O-sulfonic acid, methanesulfonic acid, m-xylene-4-sulfonic acid, poly(4-styrenesulfonic acid), polyanetholesulfonic acid, p-toluenesulfonic acid, trifluoromethane-sulfonic acid, salts thereof, and mixtures thereof. Without wishing to be bound by theory, it is believed that the chelating agent can serve as a removal rate enhancer to facilitate removal of certain materials on a substrate.

In some embodiments, the chelating agent can be from at least about 0.1% (e.g., at least about 0.2%, at least about 0.3%, at least about 0.4%, at least about 0.5%, at least about 0.6%, at least about 0.7%, at least about 0.8%, at least about 0.9%, or at least about 1%) by weight to at most about 10% (e.g., at most about 8%, at most about 6%, at most about 5%, at most about 4%, at most about 2%, at most about 1%, at most about 0.8%, at most about 0.6%, or at most about 0.5%) by weight of the polishing compositions described herein.

The water-soluble polymer is selected from the group consisting of polyacrylamide, polyvinylpyrrolidone, polyacrylic acid, and hydroxyethyl cellulose. Without wishing to be bound by theory, it is believed that the water-soluble polymer can serve as a removal rate inhibitor to reduce the removal rate of certain exposed materials on a substrate that do not intend to be removed or should be removed at a lower removal rate during the polishing process.

In some embodiments, the water-soluble polymer can be from at least about 0.01% (e.g., at least about 0.02%, at least about 0.03%, at least about 0.04%, at least about 0.05%, at least about 0.06%, at least about 0.07%, at least about 0.08%, at least about 0.09%, or at least about 0.1%) by weight to at most about 1% (e.g., at most about 0.8%, at most about 0.6%, at most about 0.5%, at most about 0.4%, at most about 0.2%, at most about 0.1%, at most about 0.08%, at most about 0.06%, or at most about 0.05%) by weight of the polishing compositions described herein.

In one or more embodiments, the nitride removal rate reducing agent is a compound that includes a hydrophobic portion containing a C₁₂ to C₄₀ hydrocarbon group (e.g., containing an alkyl group and/or an alkenyl group); and a hydrophilic portion containing at least one group selected from the group consisting of a sulfinite group, a sulfate group, a sulfonate group, a carboxylate group, a phosphate group, and a phosphonate group. In one or more embodiments, the hydrophobic portion and the hydrophilic portion are separated by zero to ten (e.g., 1, 2, 3, 4, 5, 6, 7, 8, or 9) alkylene oxide groups (e.g., -(CH₂)ₙO- groups in which n can be 1, 2, 3, or 4). In one or more embodiments, the nitride removal rate reducing agent has zero alkylene oxide groups separating the hydrophobic portion and the hydrophilic portion. Without wishing to be bound by theory, it is believed that the presence of alkylene oxide groups within the nitride removal rate reducing agent may not be preferred in some embodiments as they may create slurry stability issues and increase silicon nitride removal rate.

In one or more embodiments, the nitride removal rate reducing agent has a hydrophobic portion containing a hydrocarbon group that includes at least 12 carbon atoms (C₁₂) (e.g., at least 14 carbon atoms (C₁₄), at least 16 carbon atoms (C₁₆), at least 18 carbon atoms (C₁₈), at least 20 carbon atoms (C₂₀), or at least 22 carbon atoms (C₂₂)) and/or at most 40 carbon atoms (C₄₀) (e.g., at most 38 carbon atoms (C₃₈), at most 36 carbon atoms (C₃₆), at most 34 carbon atoms (C₃₄), at most 32 carbon atoms (C₃₂), at most 30 carbon atoms (C₃₀), at most 28 carbon atoms (C₂₈), at most 26 carbon atoms (C₂₆), at most 24 carbon atoms (C₂₄), or at most 22 carbon atoms (C₂₂)). The hydrocarbon groups mentioned herein refer to groups that contain only carbon and hydrogen atoms and can include both saturated groups (e.g., linear, branched, or cyclic alkyl groups) and unsaturated groups (e.g., linear, branched, or cyclic alkyenyl groups; linear, branched, or cyclic alkynyl groups; or aromatic groups (e.g., phenyl or naphthyl)). In one or more embodiments, the hydrophilic portion of the nitride removal rate reducing agent contains at least one group selected from a phosphate group and a phosphonate group. It is to be noted that the term "phosphonate group" is expressly intended to include phosphonic acid groups.

In one or more embodiments, the nitride removal rate reducing agent is selected from the group consisting of napthalenesulfonic acid-formalin condensate, lauryl phosphate, myristyl phosphate, stearyl phosphate, octadecylphosphonic acid, oleyl phosphate, behenyl phosphate, octadecyl sulfate, lacceryl phosphate, oleth-3-phosphate, and oleth-10-phosphate.

In one or more embodiments, the nitride removal rate reducing agent is included in a polishing composition described herein in an amount from at least about 0.1 ppm (e.g., at least about 0.5 ppm, at least about 1 ppm, at least about 5 ppm, at least about 10 ppm, at least about 25 ppm, at least about 50 ppm, at least about 75 ppm, or at least about 100 ppm) to at most about 1000 ppm (e.g., at most about 900 ppm, at most about 800 ppm, at most about 700 ppm, at most about 600 ppm, at most about 500 ppm, or at most about 250 ppm) based on the total weight of the composition.

In one or more embodiments, the polishing compositions described herein can be substantially free of one or more of certain ingredients, such as organic solvents, pH adjustors (e.g., acids or bases), fluorine containing compounds (e.g., fluoride compounds or fluorinated polymers/surfactants), silicon containing compounds such as silanes (e.g., alkoxysilanes), nitrogen containing compounds (e.g., amino acids, amines, or imines (e.g., amidines such as 1,8-diazabicyclo[5.4.0]-7-undecene (DBU) and 1,5-diazabicyclo[4.3.0]non-5-ene (DBN))), salts (e.g., halide salts or metal salts), polymers (e.g., cationic, or anionic polymers) such as polyols, inorganic acids (e.g., hydrochloric acid, sulfuric acid, phosphoric acid, or nitric acid), surfactants (e.g., cationic surfactants, anionic surfactants, non-ionic surfactants, or those other than the biosurfactant described herein), plasticizers, oxidizing agents (e.g., H₂O₂), quaternary ammonium compounds (e.g., salts such as tetraalkylammonium salts or hydroxides such as tetramethylammonium hydroxide), corrosion inhibitors (e.g., azole or non-azole corrosion inhibitors), electrolytes (e.g., polyelectrolytes), and/or certain abrasives (e.g., ceria abrasives or non-ionic abrasives). The halide salts that can be excluded from the polishing compositions include alkali metal halides (e.g., sodium halides or potassium halides) or ammonium halides (e.g., ammonium chloride), and can be fluorides, chlorides, bromides, or iodides. As used herein, an ingredient that is "substantially free" from a polishing composition refers to an ingredient that is not intentionally added into the polishing composition. In some embodiments, the polishing compositions described herein can have at most about 1000 ppm (e.g., at most about 500 ppm, at most about 250 ppm, at most about 100 ppm, at most about 50 ppm, at most about 10 ppm, or at most about 1 ppm) of one or more of the above ingredients that are substantially free from the polishing compositions. In some embodiments, the polishing compositions described can be completely free of one or more of the above ingredients.

In one or more embodiments, this disclosure features a method of polishing that can include applying a polishing composition according to the present disclosure to a surface of a substrate (e.g., a wafer); and bringing a pad (e.g., a polishing pad) into contact with the surface of the substrate and moving the pad in relation to the substrate. In one or more embodiments, the substrate can include at least one of silicon oxides (e.g., tetraethyl orthosilicate (TEOS), high density plasma oxide (HDP), high aspect ratio process oxide (HARP), or borophosphosilicate glass (BPSG)), spin on films (e.g., films based on inorganic particle or films based on crosslinkable carbon polymer), silicon nitride, silicon carbide, high-K dielectrics (e.g., metal oxides of hafnium, aluminum, or zirconium), silicon (e.g., polysilicon, single crystalline silicon, or amorphous silicon), carbon, metals (e.g., tungsten, copper, cobalt, ruthenium, molybdenum, titanium, tantalum, or aluminum), metal nitrides (e.g., titanium nitride or tantalum nitride), and mixtures or combinations thereof.

In some embodiments, the method that uses a polishing composition described herein can further include one or more additional steps (e.g., metal or dielectric deposition on a substrate) to produce a semiconductor device from the substrate treated by the polishing composition. For example, the method can include one or more of the following steps prior to the polishing method described above: (1) depositing silicon oxide (e.g., thermal silicon oxide) on a substrate (e.g., a silicon wafer) to form a silicon oxide layer, (2) depositing silicon nitride on the silicon oxide layer to form a silicon nitride layer, (3) etching the substrate to form trenches and non-trench areas, and (4) depositing silicon oxide to the etched substrate to fill the trenches with silicon oxide. As another example, the method can include at least one additional step after the polishing method described above, such as etching the substrate (e.g., to remove silicon nitride and silicon oxide) to expose silicon and/or silicon oxide or other heterogeneous films on the wafer substrate.

In one or more embodiments, the method that uses a polishing composition described herein can further include producing a semiconductor device from the substrate treated by the polishing composition through one or more steps. For example, photolithography, ion implantation, dry/wet etching, plasma etching, deposition (e.g., PVD, CVD, ALD, ECD), wafer mounting, die cutting, packaging, and testing can be used to produce a semiconductor device from the substrate treated by the polishing composition described herein.

### EXAMPLES

In these examples, the polishing was performed on 200 mm wafers using a Mirra CMP polisher with a Fujibo H804 pad and a slurry flow rate between 150 mL/min and 250 mL/min.

The general compositions used in the examples are shown in Table 1 below. The specific details on the differences in the compositions tested will be explained in further detail when discussing the respective examples.

**TABLE 1**

| **Component** | **% By Weight of the Composition** |
|---|---|
| Organic Acid | 0.001 - 2 |
| Nitride Removal Rate Reducing Agent (C₁₂-C₂₀ phosphate) | 0.001 - 0.5 (if used) |
| Biosurfactant | 0.001 - 0.5 (if used) |
| Abrasive (silica) | 0.1 - 5 |
| Solvent (DI Water) | 75-99 |
| pH | 1-4 |

### Example 1

The removal rates (RR) for silicon nitride, silicon oxide (TEOS), and polysilicon blanket wafers were measured when polishing the wafers using Compositions 1-6. Compositions 1-6 were the same except for the differences indicated in Table 2 below. Table 2 also summarizes the test results.

**TABLE 2**

| | Comp. 1 | Comp. 2 | Comp. 3 | Comp. 4 | Comp. 5 | Comp. 6 |
|---|---|---|---|---|---|---|
| NRRR/BS Concentration | 0/0 | 0/2X | 0/10X | 1X/0 | 1X/2X | 1X/10X |
| TEOS RR (Å/min) | 522 | 527 | 305 | 357 | 410 | 390 |
| SiN RR (Å/min) | 88 | 88.2 | 87.5 | 3.81 | 5.51 | 8.21 |
| Polysilicon RR (Å/min) | 90.9 | 98.6 | 320 | 107 | 110 | 304 |
| TEOS/SiN RR ratio | 5.93 | 5.97 | 3.49 | 93.7 | 74.4 | 47.5 |
| Polysilicon/SiN RR ratio | 1.03 | 1.12 | 3.66 | 28.1 | 20 | 37 |
| Normalized Defects on silicon nitride | N/A | N/A | N/A | 1 | 0.59 | 0.45 |

| | | | | | | |
|---|---|---|---|---|---|---|
| NRRR = Nitride Removal Rate Reducing Agent; BS = Biosurfactant | | | | | | |

The results show that the biosurfactant increased the polysilicon removal rate at the highest loading. Further, the addition of the biosurfactant resulted in only a modest increase in silicon nitride rates, while silicon nitride rates typically increase significantly when a secondary surfactant/polymer that is not a biosurfactant is added to the above polishing compositions (see Example 2 below). Further, the NRRR produces high organic defect counts on silicon nitride (see Comp. 4), but the addition of the biosurfacant appears to perform as an in-situ cleaner during polishing, resulting in much lower organic defects counts on silicon nitride.

### Example 2

The removal rates for silicon nitride, silicon oxide (TEOS), and polysilicon blanket wafers were measured when polishing the wafers using Compositions 7-11. Compositions 7-11 each included 1X NRRR (i.e., a surfactant) and were the same except for Composition 7 did not include any surfactant other than the NRRR, Composition 8 included 10X biosurfactant, Composition 9 included 10X anionic polymer, and Compositions 10-11 included 10X of one of two chemically distinct non-ionic surfactants that are not biosurfactants. Table 3 summarizes the test results.

**TABLE 3**

| | Comp. 7 | Comp. 8 | Comp. 9 | Comp. 10 | Comp. 11 |
|---|---|---|---|---|---|
| TEOS RR (Å/min) | 836 | 765 | 611 | 695 | 532 |
| SiN RR (Å/min) | 10.9 | 14.6 | 82.3 | 40 | 110 |
| TEOS/SiN RR ratio | 76.7 | 52.4 | 7.42 | 17.4 | 4.84 |

The results show that, as mentioned above, the inclusion of a co-surfactant/polymer that is not a biosurfactant to a polishing composition using the NRRR commonly results in a significant increase in the silicon nitride removal rate, thereby decreasing the TEOS/SiN removal rate ratio (Compositions 9-11). These compositions have a decreased TEOS/SiN removal selectivity, which is undesirable when these compositions are designed to remove TEOS but stop on SiN. By contrast, the inclusion of biosurfactant in Composition 8 results in only a slight increase in the silicon nitride removal rate and a slight decrease in the TEOS/SiN removal rate ratio, but a significant decrease in the defects left behind by the NRRR (See Comp. 6 in Table 2 above).

### Example 3

The removal rate for silicon nitride, silicon oxide (TEOS), and polysilicon blanket wafers was measured when polishing the wafers using Compositions 12-20. Compositions 12-20 did not include the NRRR and were otherwise the same except for the differences indicated in Table 4 below. Table 4 also summarizes the test results.

**TABLE 4**

| | Comp. 12 | Comp. 13 | Comp. 14 | Comp. 15 | Comp. 16 | Comp. 17 | Comp. 18 | Comp. 19 | Comp. 20 |
|---|---|---|---|---|---|---|---|---|---|
| Abrasive | Anionic | Anionic | Anionic | Cationic | Cationic | Cationic | Neutral | Neutral | Neutral |
| Biosurfactant | 0 | 10X | 20X | 0 | 10X | 20X | 0 | 10X | 20X |
| TEOS RR (Å/min) | 227 | 195 | 212 | 746 | 698 | 862 | 1354 | 1316 | 752 |
| SiN RR (Å/min) | 481 | 490 | 502 | 97 | 108 | 50.1 | 153 | 136 | 87.6 |
| Polysilicon RR (Å/min) | 43.7 | 90.9 | 120 | 162 | 404 | 464 | 68 | 465 | 489 |
| TEOS/SiN RR ratio | 0.47 | 0.40 | 0.42 | 7.69 | 6.46 | 17.2 | 8.85 | 9.68 | 8.58 |
| Polysilicon/SiN RR ratio | 0.09 | 0.19 | 0.24 | 1.67 | 3.74 | 9.26 | 0.44 | 3.42 | 5.58 |

The results show that including a biosurfactant in a polishing composition resulted in a significant enhancement of polysilicon removal rate with increasing amounts of biosurfactant across all abrasive types. Additionally, there was a reduction in silicon nitride removal rate when using the neutral and cationic abrasive, which makes the biosurfactant a suitable replacement for the NRRR given that the NRRR leaves organic residue defects behind when included in a polishing composition. Such polishing compositions can be advantageous as they can be used to remove TEOS but stop on SiN without generating a large amount of defects on silicon nitride.

While this disclosure has been described with respect to the examples set forth herein, it is understood that other modifications and variations are possible without departing from the scope of the disclosure as defined in the appended claims.

## Claims

1. A polishing composition, comprising:
at least one abrasive;
at least one pH adjuster; and
at least one biosurfactant selected from the group consisting of glycolipids, lipopeptides, and mixtures thereof,
wherein the polishing composition is free of non-ionic polymers.

2. The polishing composition of claim 1, wherein the at least one abrasive is selected from the group consisting of alumina, silica, titania, ceria, zirconia, co-formed products of alumina, silica, titania, ceria, or zirconia, coated abrasives, surface modified abrasives, and mixtures thereof, and/or wherein the at least one abrasive is in an amount of from about 0.01% to about 50% by weight of the composition.

3. The polishing composition of claim 1 or 2, wherein the at least one biosurfactant comprises a glycolipid selected from the group consisting of a rhamnolipid, a sophorolipid, a trehalose lipid, a mannosylerythritol lipid, and mixtures thereof.

4. The polishing composition of claim 3, wherein the at least one biosurfactant comprises a rhamnolipid selected from the group consisting of a mono-rhamnolipid, a di-rhamnolipid, or a mixture thereof.

5. The polishing composition of claim 3, wherein the at least one biosurfactant comprises a sophorolipid of formula (III): 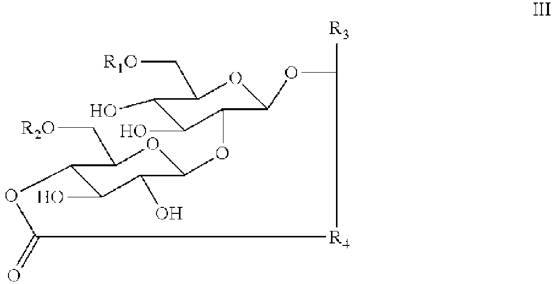 in which R₁ and R₂ each represent H or COCH₃; R₃ represents H or CH₃; and R₄ represents a saturated or unsaturated C₁₂-₁₆ hydrocarbon group when R₃ is H, and R₄ represents a saturated or unsaturated C₁₁-₁₅ hydrocarbon group when R₃ is CH₃.

6. The polishing composition of claim 3, wherein the at least one biosurfactant comprises a sophorolipid of formula (IV): 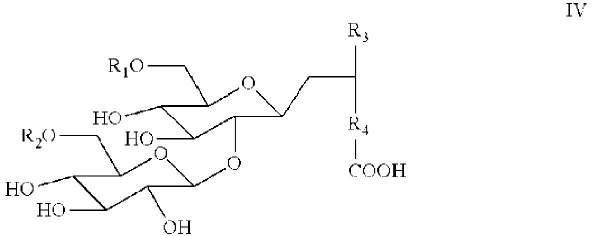 in which R₁ and R₂ each represent H or COCH₃; R₃ represents H or CH₃; and R₄ represents a saturated or unsaturated C₁₂-₁₆ hydrocarbon group when R₃ is H, and R₄ represents a saturated or unsaturated C₁₁-₁₅ hydrocarbon group when R₃ is CH₃.

7. The polishing composition of claim 3, wherein the glycolipid comprises at least about 5% to at most about 95% by weight acidic-type sophorolipid.

8. The polishing composition of claim 1 or 2, wherein the at least one biosurfactant comprises a lipopeptide selected from the group consisting of surfactin, iturin, fengycin, lichenysin, mixtures thereof.

9. The polishing composition of any one of claims 1-8, wherein the at least one biosurfactant is the only surfactant in the polishing composition, and/or wherein the at least one biosurfactant is in an amount from about 0.0001% to about 10% by weight of the composition.

10. The polishing composition of any one of claims 1-9, further comprising:
a second surfactant, distinct from the at least one biosurfactant, selected from the group consisting of anionic surfactants, non-ionic surfactants, and cationic surfactants.

11. The polishing composition of any one of claims 1-10, wherein the at least one pH adjustor is in an amount of from about 0.0001% to about 30% by weight of the composition.

12. The polishing composition of any one of claims 1-11, further comprising:
at least one additive selected from the group consisting of an azole compound, a corrosion inhibitor, an oxidizer, and a chelating agent.

13. The polishing composition of any one of claims 1-12, wherein the composition has a pH of from about 1 to about 14.

14. A method of polishing a substrate, comprising the steps of:
applying the polishing composition of any one of claims 1-13 to a surface of the substrate; and
bringing a pad into contact with the surface of the substrate and moving the pad in relation to the substrate.

15. The method of claim 14, wherein the substrate is a wafer having a surface comprising SiN, SiC, TiN, TaN, W, silicon oxides, Cu, Co, Ru, Mo, Ti, Ta, Al, carbon, silicon, hafnium oxide, aluminum oxide, zirconium oxide, or p-Si, or a combination thereof.

## Patentansprüche

1. Polierzusammensetzung umfassend:
wenigstens einen Abrasivstoff;
wenigstens ein pH-Einstellmittel; und
wenigstens ein Biotensid ausgewählt aus der Gruppe bestehend aus Glycolipiden, Lipopeptiden und Gemischen davon,
wobei die Polierzusammensetzung frei von nichtionischen Polymeren ist.

2. Polierzusammensetzung nach Anspruch 1, wobei der wenigstens eine Abrasivstoff ausgewählt ist aus der Gruppe bestehend aus Aluminiumoxid, Siliciumdioxid, Titandioxid, Ceroxid, Zirkoniumdioxid, co-geformten Produkten aus Aluminiumoxid, Siliciumdioxid, Titandioxid, Ceroxid oder Zirkoniumdioxid, beschichteten Abrasivstoffen, oberflächenmodifizierten Abrasivstoffen und Gemischen davon, und/oder wobei der wenigstens eine Abrasivstoff in einer Menge von etwa 0,01 Gew.-% bis etwa 50 Gew.-% der Zusammensetzung vorliegt.

3. Polierzusammensetzung nach Anspruch 1 oder 2, wobei das wenigstens eine Biotensid ein Glycolipid ausgewählt aus der Gruppe bestehend aus einem Rhamnolipid, einem Sophorolipid, einem Trehaloselipid, einem Mannosylerythritollipid und Gemischen davon umfasst.

4. Polierzusammensetzung nach Anspruch 3, wobei das wenigstens eine Biotensid ein Rhamnolipid ausgewählt aus der Gruppe bestehend aus einem Mono-Rhamnolipid, einem Di-Rhamnolipid oder einem Gemisch davon umfasst.

5. Polierzusammensetzung nach Anspruch 3, wobei das wenigstens eine Biotensid ein Sophorolipid der Formel (III) umfasst: 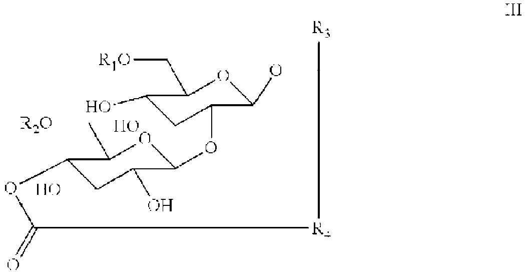 wobei R₁ und R₂ jeweils H oder COCH₃ darstellen; R₃ H oder CH₃ darstellt; und R₄ eine gesättigte oder ungesättigte C₁₂₋₁₆-Kohlenwasserstoffgruppe darstellt, wenn R₃ H ist, und R₄ eine gesättigte oder ungesättigte C₁₁₋₁₅-Kohlenwasserstoffgruppe darstellt, wenn R₃ CH₃ ist.

6. Polierzusammensetzung nach Anspruch 3, wobei das wenigstens eine Biotensid ein Sophorolipid der Formel (IV) umfasst: 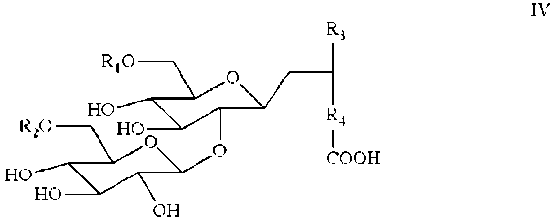 wobei R₁ und R₂ jeweils H oder COCH₃ darstellen; R₃ H oder CH₃ darstellt; und R₄ eine gesättigte oder ungesättigte C₁₂₋₁₆-Kohlenwasserstoffgruppe darstellt, wenn R₃ H ist, und R₄ eine gesättigte oder ungesättigte C₁₁₋₁₅-Kohlenwasserstoffgruppe darstellt, wenn R₃ CH₃ ist.

7. Polierzusammensetzung nach Anspruch 3, wobei das Glycolipid wenigstens etwa 5 Gew.-% bis höchstens etwa 95 Gew.-% Sophorolipid vom sauren Typ umfasst.

8. Polierzusammensetzung nach Anspruch 1 oder 2, wobei das wenigstens eine Biotensid ein Lipopeptid ausgewählt aus der Gruppe bestehend aus Surfactin, Iturin, Fengycin, Lichenysin, Gemischen davon umfasst.

9. Polierzusammensetzung nach einem der Ansprüche 1-8, wobei das wenigstens eine Biotensid das einzige Tensid in der Polierzusammensetzung ist und/oder wobei das wenigstens eine Biotensid in einer Menge von etwa 0,0001 Gew.-% bis etwa 10 Gew.-% der Zusammensetzung vorliegt.

10. Polierzusammensetzung nach einem der Ansprüche 1-9, ferner umfassend:
ein zweites Tensid, das von dem wenigstens einen Biotensid verschieden ist, ausgewählt aus der Gruppe bestehend aus anionischen Tensiden, nichtionischen Tensiden und kationischen Tensiden.

11. Polierzusammensetzung nach einem der Ansprüche 1-10, wobei das wenigstens eine pH-Einstellmittel in einer Menge von etwa 0,0001 Gew.-% bis etwa 30 Gew.-% der Zusammensetzung vorliegt.

12. Polierzusammensetzung nach einem der Ansprüche 1-11, ferner umfassend:
wenigstens einen Zusatzstoff ausgewählt aus der Gruppe bestehend aus einer Azolverbindung, einem Korrosionshemmer, einem Oxidationsmittel und einem Chelatbildner.

13. Polierzusammensetzung nach einem der Ansprüche 1-12, wobei die Zusammensetzung einen pH-Wert von etwa 1 bis etwa 14 aufweist.

14. Verfahren zum Polieren eines Substrats, umfassend die Schritte:
Aufbringen der Polierzusammensetzung nach einem der Ansprüche 1-13 auf eine Oberfläche des Substrats; und
Inkontaktbringen eines Kissens mit der Oberfläche des Substrats und Bewegen des Kissens bezogen auf das Substrat.

15. Verfahren nach Anspruch 14, wobei das Substrat ein Wafer mit einer Oberfläche ist, die SiN, SiC, TiN, TaN, W, Siliciumoxide, Cu, Co, Ru, Mo, Ti, Ta, Al, Kohlenstoff, Silicium, Hafniumoxid, Aluminiumoxid, Zirkoniumoxid oder p-Si oder eine Kombination davon umfasst.

## Revendications

1. Composition de polissage, comprenant :
au moins un abrasif ;
au moins un agent d'ajustement du pH ; et
au moins un biotensioactif choisi dans le groupe constitué par les glycolipides, les lipopeptides, et leurs mélanges,
dans laquelle la composition de polissage est exempte de polymères non ioniques.

2. Composition de polissage selon la revendication 1, dans laquelle l'au moins un abrasif est choisi dans le groupe constitué par l'alumine, la silice, l'oxyde de titane, l'oxyde de cérium, la zircone, les produits coformés d'alumine, de silice, d'oxyde de titane, d'oxyde de cérium ou de zircone, des abrasifs revêtus, des abrasifs modifiés en surface et des mélanges de ceux-ci, et/ou dans laquelle l'abrasif ou les abrasifs sont présents dans une quantité allant d'environ 0,01 % à environ 50 % en poids de la composition.

3. Composition de polissage selon la revendication 1 ou 2, dans laquelle l'au moins un biotensioactif comprend un glycolipide choisi dans le groupe constitué par un rhamnolipide, un sophorolipide, un lipide de tréhalose, un lipide de mannosylérythritol et leurs mélanges.

4. Composition de polissage selon la revendication 3, dans laquelle l'au moins un biotensioactif comprend un rhamnolipide choisi dans le groupe constitué par un mono-rhamnolipide, un di-rhamnolipide ou un mélange de ceux-ci.

5. Composition de polissage selon la revendication 3, dans laquelle l'au moins un biotensioactif comprend un sophorolipide de formule (III) : 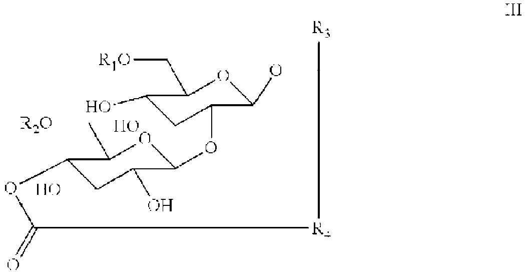 dans laquelle R₁ et R₂ représentent chacun H ou COCH₃ ; R₃ représente H ou CH₃ ; et R₄ représente un groupement hydrocarboné en C₁₂₋₁₆ saturé ou insaturé lorsque R₃ est H, et R₄ représente un groupement hydrocarboné en C₁₁₋₁₅ saturé ou insaturé lorsque R₃ est CH₃.

6. Composition de polissage selon la revendication 3, dans laquelle l'au moins un biotensioactif comprend un sophorolipide de formule (IV) : 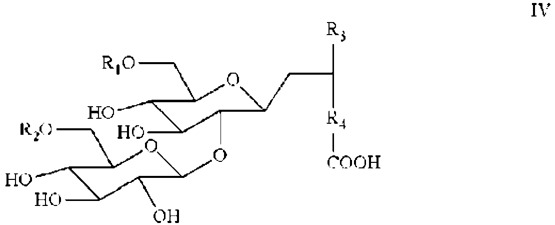 dans laquelle R₁ et R₂ représentent chacun H ou COCH₃ ; R₃ représente H ou CH₃ ; et R₄ représente un groupement hydrocarboné en C₁₂₋₁₆ saturé ou insaturé lorsque R₃ est H, et R₄ représente un groupement hydrocarboné en C₁₁₋₁₅ saturé ou insaturé lorsque R₃ est CH₃.

7. Composition de polissage selon la revendication 3, dans laquelle le glycolipide comprend au moins environ 5 % à au plus environ 95 % en poids de sophorolipide de type acide.

8. Composition de polissage selon la revendication 1 ou 2, dans laquelle l'au moins un biotensioactif comprend un lipopeptide choisi dans le groupe constitué par la surfactine, l'iturine, la fengycine, la lichenysine, leurs mélanges.

9. Composition de polissage selon l'une quelconque des revendications 1 à 8, dans laquelle l'au moins un biotensioactif est le seul tensioactif dans la composition de polissage, et/ou dans laquelle l'au moins un biotensioactif est présent en une quantité d'environ 0,0001 % à environ 10 % en poids de la composition.

10. Composition de polissage selon l'une quelconque des revendications 1 à 9, comprenant en outre :
un deuxième tensioactif, distinct dudit au moins un biotensioactif, choisi dans le groupe constitué par les tensioactifs anioniques, les tensioactifs non ioniques et les tensioactifs cationiques.

11. Composition de polissage selon l'une quelconque des revendications 1 à 10, dans laquelle l'au moins un agent d'ajustement du pH est présent en une quantité d'environ 0,0001 % à environ 30 % en poids de la composition.

12. Composition de polissage selon l'une quelconque des revendications 1 à 11, comprenant en outre :
au moins un additif choisi dans le groupe constitué par un composé azole, un inhibiteur de corrosion, un oxydant et un agent chélatant.

13. Composition de polissage selon l'une quelconque des revendications 1 à 12, dans laquelle la composition a un pH d'environ 1 à environ 14.

14. Procédé de polissage d'un substrat, comprenant les étapes de :
application de la composition de polissage selon l'une quelconque des revendications 1-13 sur une surface du substrat ; et
mise en contact d'un tampon avec la surface du substrat et déplacement du tampon par rapport au substrat.

15. Procédé selon la revendication 14, dans lequel le substrat est une plaquette ayant une surface comprenant SiN, SiC, TiN, TaN, W, oxydes de silicium, Cu, Co, Ru, Mo, Ti, Ta, Al, carbone, silicium, oxyde d'hafnium, oxyde d'aluminium, oxyde de zirconium, ou p-Si, ou une combinaison de ceux-ci.
